# EUROPÄISCHE PATENTSCHRIFT

(11) **EP 0 657 563 B1**
(45) Veröffentlichungstag und Bekanntmachung des Hinweises auf die Patenterteilung: **19.08.1998**
(21) Anmeldenummer: 94108188.7
(22) Anmeldetag: 27.05.1994
(51) Int. Cl.: C23C 14/56, C23C 14/34

(54) **Vakuumbeschichtungsanlage**
Vacuum coating apparatus
Appareil de revêtement sous vide

(30) Priorität: 07.12.1993 DE 4341635
(43) Veröffentlichungstag der Anmeldung: 14.06.1995
(73) Patentinhaber: Balzers und Leybold Deutschland Holding Aktiengesellschaft, 63450 Hanau (DE)
(72) Erfinder: Zejda, Jaroslav, D-63517 Rodenbach (DE); Henrich, Jürgen, D-63694 Limeshain (DE)

(56) Entgegenhaltungen:
- EP-A- 0 443 049

## Beschreibung

Die Erfindung betrifft eine Vakuumbeschichtungsanlage zum Aufbringen dünner Schichten auf Substrate, mit einer Eintrittskammer, mindestens einer weiteren Kammer zur Behandlung der Substrate und mit einer Austrittskammer, sowie mit einer in einer evakuierbaren Transportkammer angeordneten Fördereinrichtung zum Transport der Substrate durch die Kammern, wobei die Fördereinrichtung um eine gemeinsame Achse herum angeordnet und um diese schwenkbare Halterungen aufweist, wobei in wenigstens zwei Positionen, nämlich einer Ein- und Austrittsposition und einer Behandlungsposition die Halterungen jeweils gegenüber der Transportkammerwand auf- und abbewegbar sind, wobei diese Auf- und Abbewegung in der ersten Position so bemessen ist, daß die Halterung in der angehobenen Position die Öffnung der Austrittskammer in der Wand der Transportkammer verschließt.

Ein Nachteil bekannter Vorrichtungen liegt in einer aufwendigen Bauweise und oft auch darin, daß sie nur für ganz bestimmtes Beschichtungsgut verwendbar sind. Das Aus- und Einschleusen des Beschichtungsgutes ergab oft schwierige Dichtungsprobleme, die durch aufwendige Schleusenkonstruktionen gelöst wurden.

Aus der DE-OS 22 41 634 ist eine Vakuumbeschichtungsanlage der eingangs genannten Art bekannt, bei der die Fördereinrichtung um eine gemeinsame Achse herum angeordnete und um diese schwenkbare topfförmige Rahmen für die Aufnahme des zu beschichtenden Gutes aufweist, wobei in einer Behandlungsposition, nämlich in der Ein- und Ausschleusposition, ein solcher Rahmen selbst Teil der Wand der Ein- und Austrittskammer bildet und eine bewegliche Ventilplatte zum Absperren einer Stirnseite des einen Teils der Ein- und Austrittskammer bildenden Rahmens vorgesehen ist. Bei dieser bekannten Vakuumbeschichtungsanlage ist das Ein- und Ausschleusen des zu beschichtenden Gutes konstruktiv einfach gelöst. Die Weiterbewegung des zu beschichtenden Gutes insbesondere in die Aufdampfposition ist jedoch kompliziert. Der das Gut enthaltende topfförmige Rahmen wird durch Weiterdrehen der Fördereinrichtung in eine Übergabeposition gebracht, aus der die einzelnen Substrate durch eine von unten her angreifende Hubvorrichtung aus dem topfförmigen Rahmen herausgehoben und nach oben in die eigentliche Aufdampfkammer bewegt werden. Hierdurch ergibt sich nicht nur ein erheblicher konstruktiver Aufwand, sondern auch ein komplizierter und zeitraubender Betriebsablauf.

Aus der DE 24 54 544 ist weiterhin eine Vakuumbeschichtungsanlage zum Aufdampfen dünner Schichten auf Substrate bekannt, mit einer Eintrittskammer, weiteren Kammern zur Behandlung bzw. Beschichtung der Substrate und mit einer Austrittskammer sowie mit einer in einer evakuierbaren Hauptkammer angeordneten Fördereinrichtung zum Transport der Substrate durch die Kammern, wobei Abdichteinrichtungen zur zeitweisen Abdichtung zwischen den genannten Kammern und der Hauptkammer vorgesehen sind und bei der die Fördereinrichtung um eine gemeinsame Achse herum angeordnete und um diese schwenkbare Rahmen für die Aufnahme des zu beschichtenden Gutes aufweist, wobei in wenigstens zwei Behandlungspositionen, nämlich einer Ein- und Austrittsposition und einer Aufdampfposition, ein solcher Rahmen selbst Teil der Wand einer Behandlungskammer, nämlich der Ein- und Austrittskammer und einer Aufdampfkammer bildet, wobei in mindestens einer dieser Behandlungspositionen eine bewegliche Ventilplatte zum Absperren einer Stirnseite des einen Teils der die Behandlungskammer bildenden Rahmens vorgesehen ist.

Der vorliegenden Erfindung liegt die Aufgabe zugrunde, eine Vorrichtung des infrage stehenden Typs zu schaffen, bei der die Substrate in besonderen Behältnissen angeordnet sind, die zusammen mit den Substraten in die Vorrichtung eingeschleust werden können und die eine Kontamination infolge des Beschichtungsprozesses der Innenräume und der Transporteinrichtung verhindern. Die Vorrichtung soll darüber hinaus so gestaltet sein, daß Behältnisse verschiedener Größe Verwendung finden können.

Erfindungsgemäß wird diese Aufgabe dadurch gelöst, daß die Anlage topfförmige Behälter aufweist, wobei auf jede Halterung jeweils ein topfförmiger Behälter zur Aufnahme eines Substrates aufsetzbar ist und der Außendurchmesser jedes Behälters geringer bemessen ist, als der Innendurchmesser der Ein-/Austrittsöffnung und die Höhe jedes Behälters mindestens der Gesamthubhöhe der Halterungen entspricht und der Behälter vom Hubmotor im Bereich der Behandlungsposition aufwärts bewegbar ist, bis der obere des Behälters sich dichtend an den Rand der Öffnung für die Behandlungskammer oder an einen in die Öffnung eingesetzten, diese verengenden Kragen oder Maske anlegt, wobei der von der Öffnung in der Wand oder vom Kragen oder von der Maske bestimmte Öffnungsdurchmesser geringer bemessen ist, als der Außendurchmesser des oberen Behälterrandes.

Die Erfindung läßt die verschiedensten Ausführungsmöglichkeiten zu; eine davon ist in der anhängenden Zeichnung schematisch näher dargestellt, die den Längsschnitt durch die Vorrichtung zeigt.

Die Vorrichtung besteht aus einem im wesentlichen kreiszylindrischen Gehäuse 2 mit einem die Oberseite verschließenden Wandteil 11, einem Bodenteil 18 und einem Seitenwandteil 19, einer in der Transportkammer 6 im Gehäuse 2 mit einer Welle 20 drehfest verbundene kreisscheibenförmige Fördereinrichtung 7, den die Welle 20 bzw. die Fördereinrichtung 7 antreibenden, den Motor 21, den beiden am Bodenteil 18 befestigten Hubmotoren 22,23, deren Stößel 24,25 die auf der Fördereinrichtung 7 angeordneten Halterungen 9,10 anheben oder absenken, der Vakuumpumpe 26, den beiden auf den Halterungen 9,10 aufliegenden topfförmigen Behältern 12,13 zur Aufnahme der Substrate 3,3' ,..., den auf dem oberen Wandteil 11 des Gehäuses 2 schwenkbar gelagerten Schließteller 27 und der Kathodenanordnung 28 mit den zugehörigen Targets 29,30 und Magnetanordnungen 31,32, die insgesamt um einen Bolzen 33 in Pfeilrichtung A schwenkbar gelagert ist, was den Zugang zu den Targets 29,30 und zu der Behandlungskammer 5 ermöglicht.

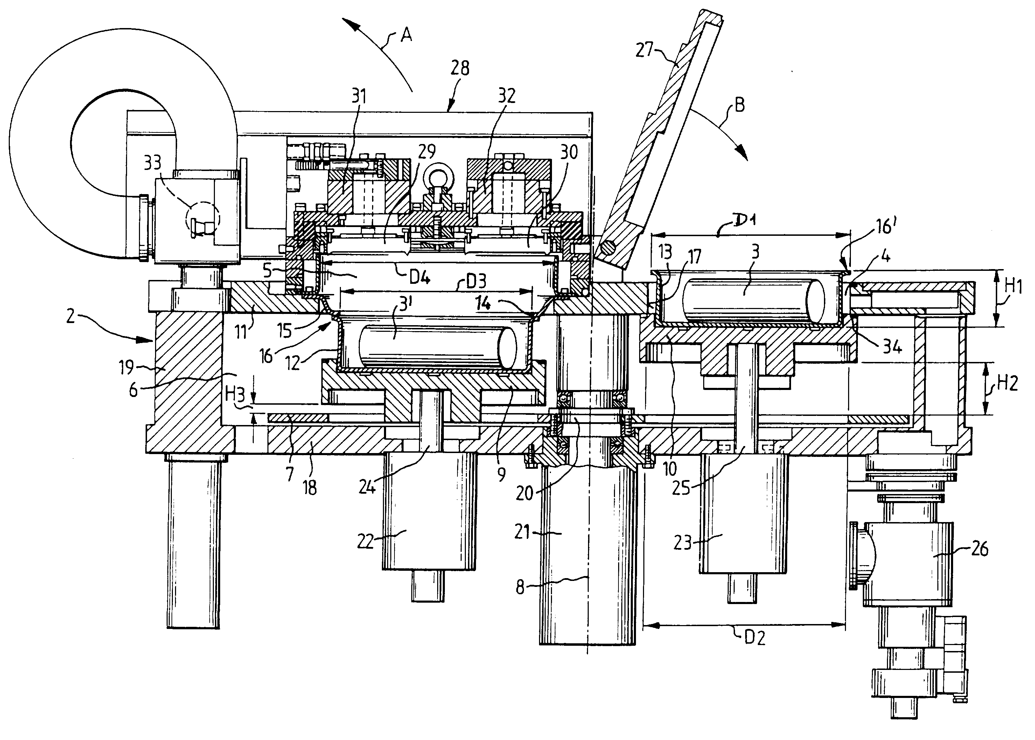

Die Abbildung zeigt die Vorrichtung mit geöffneten Schließteller 27 und mit in den topfförmigen Behälter 13 eingelegtem Substrat 3. Der Hubmotor 23 hat hierzu die Halterung 10 mit Hilfe des Stößels 25 soweit angehoben, daß die Halterung 10 fest mit ihrer Dichtung 34 an der Unterseite der Wand 11 der Transportkammer 6 anliegt und die Öffnung 17 verschließt. Gleichzeitig hat der Hubmotor 22 über den Stößel 24 die Halterung 9 um das Maß H₃ soweit angehoben, daß der umlaufende obere Rand 16 des topfförmigen Behälters 12 an der Maske 15 anliegt, so daß die Behandlungskammer 5 nach unten zu vollständig verschlossen ist. Wie die Zeichnung zeigt, ist der Durchmesser D₄ der Öffnung im Wandteil 11 des Gehäuses 2 größer bemessen, als der Durchmesser D₁ des topfförmigen Behälters 12 bzw. 13.

In der in der Abbildung dargestellten Phase des Beschichtungsprozesses befindet sich das Substrat 3 im Behälter 13 in der Einschleusposition und das Substrat 3' im Behälter 12 in der Behandlungs- bzw. Beschichtungsposition. Nach Beendigung des Beschichtungsvorgangs mit Hilfe der Kathodenanordnung 28 verschließt der Schließteller 27 die Kammer 4 und die Halterung 10 bewegt sich um das Maß H₂ nach unten und zwar soweit, bis der obere umlaufende Rand 16' des topfförmigen Behälters 13 sich unterhalb der Unterseite des Wandteils 11 befindet. Gleichzeitig wird auch die Halterung 9 um das Maß H₃ abgesenkt. Anschließend wird die Fördereinrichtung 7 um 180° gedreht, so daß der Behälter 12 mit dem Substrat 3' sich in der Position unterhalb der Kammer 4 befindet und das Substrat 3 zusammen mit dem Behälter 13 und der Halterung 10 unterhalb der Behandlungskammer 5. Beide Hubmotore 22,23 werden nun aktiviert, so daß die Behälter 12,13 angehoben werden, so daß das Substrat 3' nach dem Öffnen des Schließtellers 27 dem Behälter 12 entnommen und das Substrat 3 von der Kathode 28 beschichtet werden kann. Von hier ab wiederholen sich die vorstehend beschriebenen Abläufe, so daß nach dem Ausschleusen des Substrats 3' ein weiteres Substrat 3" ... usw. eingeschleust, transportiert und beschichtet werden kann.

Es ist klar, daß das Maß H₂, also die Hubhöhe des Stößels 25 so bemessen sein muß, daß der Behälter 13 einerseits soweit absenkbar ist, bis sich sein oberer Rand 16' unterhalb der unteren Fläche des Wandteils 11 befindet und andererseits soweit anhebbar ist, daß der Behälter von oben her (bei geöffnetem Schließteller 27) bequem entnehmbar ist. Weiterhin ist klar, daß die Hubhöhe H₃ des Stößels 24 so bemessen sein muß, daß einerseits der Behälter 12 mit seinem oberen Randteil 16 die Öffnung zwischen der Behandlungskammer 5 und der Transportkammer 6 verschließen kann und andererseits soweit absenkbar ist, daß ein Ringspalt zwischen seinem oberen Rand 16 und der unteren Fläche des Wandteils 11 entsteht, der groß genug ist, den Behälter 12 unbehindert von der Behandlungsposition in die Ein-/Ausschleusposition zu transportieren.

### Bezugszeichenliste

- 2: kreiszylindrisches Gehäuse
- 3,3',: Substrat
- 4: Eintrittskammer/Austrittskammer
- 5: Behandlungskammer
- 6: Transportkammer
- 7: Fördereinrichtung
- 8: Achse
- 9: Halterung
- 10: Halterung
- 11: Wand der Transportkammer, Wandteil
- 12: topfförmiger Behälter
- 13: topfförmiger Behälter
- 14: Rand der Öffnung
- 15: Kragen, Maske
- 16,16': oberer Rand
- 17: Öffnung
- 18: Bodenteil des Gehäuses
- 19: Seitenwandteil
- 20: Antriebswelle
- 21: Antriebsmotor
- 22: Hubmotor
- 23: Hubmotor
- 24: Stößel
- 25: Stößel
- 26: Vakuumpumpe
- 27: Schließteller
- 28: Kathodenanordnung
- 29: Target
- 30: Target
- 31: Magnet
- 32: Magnet
- 33: Bolzen
- 34: Dichtring

## Patentansprüche

1. Vakuumbeschichtungsanlage zum Aufbringen dünner Schichten auf Substrate (3,3',...), mit einer Eintrittskammer (4), mindestens einer weiteren Kammer (5) zur Behandlung der Substrate (3,3',...) und mit einer Austrittskammer (4) sowie mit einer in einer evakuierbaren Transportkammer (6) angeordneten Fördereinrichtung (7) zum Transport der Substrate (3,3',...) durch die Kammern (4,5,6), wobei die Fördereinrichtung (7) um eine gemeinsame Achse (8) herum angeordnet und um diese schwenkbare Halterungen (9,10) aufweist, wobei in wenigstens zwei Positionen, nämlich einer Ein- und Austrittsposition und einer Behandlungsposition die Halterungen (9,10) jeweils gegenüber der Wand (11) der Transportkammer (6) auf- und abbewegbar sind, wobei diese Auf- und Abbewegung in der ersten Position so bemessen ist, daß die Halterung (10) in der angehobenen Position die Öffnung (17) der Ein/Austrittskammer (4) in der Wand (11) der Transportkammer (6) verschließt, **dadurch gekennzeichnet,** daß die Anlage topfförmige Behälter (12, 13) aufweist, wobei auf jede Halterung (9,10) jeweils ein topfförmiger Behälter (12,13) zur Aufnahme eines Substrates (3,3',...) aufsetzbar ist und der Außendurchmesser (D₁) jedes Behälters (12,13) geringer bemessen ist als der Innendurchmesser (D₂) der Ein-/Austrittsöffnung und die Höhe (H₁) jedes Behälters (12,13) etwa der Gesamthubhöhe der Halterungen (9,10) entspricht und der Behälter (12) vom Hubmotor (22) im Bereich der Behandlungsposition (5) aufwärts bewegbar ist, bis der obere Rand (16) des Behälters (12) sich dichtend an den Rand (14) der Öffnung für die Behandlungskammer (5) oder an einen in die Öffnung eingesetzten Kragen oder Maske (15) anlegt, wobei der von der Öffnung in der Wand (11) oder vom Kragen oder von der Maske (15) bestimmte Öffnungsdurchmesser (D₃) geringer bemessen ist als der Außendurchmesser (D₁) des oberen Randes (16) des Behälters (12,13).

## Claims

1. Vacuum coating installation for applying thin layers onto substrates (3, 3', ...), having an inlet chamber (4), at least one further chamber (5) for treating the substrates (3, 3', ...) and having an outlet chamber (4) as well as having a feed device (7) disposed in an evacuable transport chamber (6) for feeding the substrates (3, 3', ...) through the chambers (4, 5, 6), the feed device (7) being disposed around a common axis (8) and comprising holding devices (9, 10) capable of swivelling about said axis, wherein in at least two positions, namely an inlet and outlet position and a treatment position, the holding devices (9, 10) are each movable up and down relative to the wall (11) of the transport chamber (6), said upward and downward movement in the first position being so dimensioned that the holding device (10) in the raised position closes the opening (17) of the inlet/outlet chamber (4) in the wall (11) of the transport chamber (6), characterized in that the installation has pot-shaped containers (12, 13), one pot-shaped container (12, 13) being mountable onto each holding device (9, 10) for receiving a substrate (3, 3', ...), and the outside diameter (D₁) of each container (12, 13) is smaller than the inside diameter (D₂) of the inlet/outlet opening and the height (H₁) of each container (12, 13) corresponds substantially to the total height of stroke of the holding devices (9, 10) and the container (12) is movable upwards by the lifting motor (22) in the region of the treatment position (5) until the top edge (16) of the container (12) is applied sealingly against the edge (14) of the opening for the treatment chamber (5) or against a collar or mask (15) inserted into the opening, the opening diameter (D₃) defined by the opening in the wall (11) or by the collar or mask (15) being smaller than the outside diameter (D₁) of the top edge (16) of the container (12, 13).

## Revendications

1. Appareil de revêtement sous vide pour appliquer des couches minces sur des substrats (3,3',...), comportant une chambre d'entrée (4), au moins une autre chambre (5) pour le traitement des substrats (3,3',...) et comportant une chambre de sortie (4) ainsi qu'un dispositif de transport (7), disposé dans une chambre de transport (6) qui peut être mise sous vide, pour le transport des substrats (3,3',...) à travers les chambres (4,5,6), dans lequel le dispositif de transport (7) est disposé autour d'un axe commun (8) et présente des supports (9,10) qui peuvent pivoter autour de cet axe, dans lequel, en au moins deux positions, à savoir une position d'entrée et de sortie et une position de traitement, les supports (9,10) peuvent respectivement monter et descendre par rapport à la paroi (11) de la chambre de transport (6), dans lequel, dans la première position, ce mouvement de montée et de descente est dimensionné de façon que, dans la position haute, le support (10) obture l'ouverture (17) de la chambre d'entrée/sortie (4) prévue dans la paroi (11) de la chambre de transport (6), caractérisé par le fait que l'appareil présente des récipients (12, 13) en forme de boisseau, étant précisé que sur chaque support (9, 10) peut être posé un récipient en forme de boisseau (12, 13) pour recevoir un substrat (3, 3',...) et que le diamètre extérieur (D₁) de chaque récipient (12, 13) est dimensionné plus petit que le diamètre intérieur (D₂) de l'ouverture d'entrée/sortie et que la hauteur (H₁) de chaque récipient (12, 13) correspond à peu près à la hauteur de course totale des supports (9, 10) et que le récipient (12) peut être déplacé vers le haut, par le moteur de levage (22), au voisinage de la position de traitement (5), jusqu'à ce que le bord supérieur (16) du récipient (12) s'appuie, avec étanchéité, contre le bord (14) de l'ouverture prévue pour la chambre de traitement (5) ou contre un collet ou un masque (15) inséré dans l'ouverture, le diamètre d'ouverture (D₃), déterminé par l'ouverture dans la paroi (11) ou par le collet ou par le masque (15) étant dimensionné plus petit que le diamètre extérieur (D₁) du bord supérieur (16) du récipient (12, 13).
